# EUROPÄISCHE PATENTANMELDUNG

(11) **EP 4 750 307 A1**
(43) Veröffentlichungstag der Anmeldung: **27.05.2026**
(21) Anmeldenummer: 25215107.1
(22) Anmeldetag: 11.11.2025
(51) Int. Cl.: H10W 40/40, H10W 40/25, C04B 37/00, H10W 40/22

(54) **LEISTUNGSMODUL MIT KÜHLKÖRPER UND TRÄGER**

(30) Priorität: 20.11.2024 DE 102024134025
(71) Anmelder: Volkswagen Aktiengesellschaft, 38440 Wolfsburg (DE)
(72) Erfinder: Bayer, Dr. Christoph Friedrich, 38440 Wolfsburg (DE); Wilke, Dr. Robert, 38440 Wolfsburg (DE)

(57) **Zusammenfassung**

Die Erfindung betrifft ein Leistungsmodul (1) mit Kühlkörper (8), wobei das Leistungsmodul (1) mindestens einen Träger (2) aufweist, wobei der mindestens eine Träger (2) eine Isolationsschicht (3) aufweist, wobei auf der Oberseite der Isolationsschicht (3) mindestens eine erste Metallisierung (4, 7) aufgebracht ist, auf der mindestens ein Halbleiterbauelement (6) angeordnet ist, wobei an der Unterseite der Isolationsschicht (3) eine zweite Metallisierung (5) aufgebracht ist, wobei die zweite Metallisierung (5) ein erstes Teil des Kühlkörpers (8) ist und direkt mit einem Kühlmedium (9) des Kühlkörpers (8) in Kontakt steht, wobei die zweite Metallisierung (5) eine größere Fläche als die Isolationsschicht (3) aufweist, sowie einen Träger (2).

## Beschreibung

Die Erfindung betrifft ein Leistungsmodul mit Kühlkörper und einem Träger für ein solches Leistungsmodul.

Leistungsmodule weisen typischerweise einen Träger auf, der eine Isolationsschicht aufweist, wobei auf der Oberseite eine erste Metallisierung aufgebracht ist und auf der Unterseite eine zweite Metallisierung aufgebracht ist. Auf der ersten Metallisierung ist dann mindestens ein Halbleiterbauelement angeordnet, typischerweise aber mehr. Die erste Metallisierung wird dann entsprechend strukturiert, um unterschiedliche elektrische Potentiale für die Halbleiterbauelemente sowie gegebenenfalls andere Elemente wie Temperatursensoren zu ermöglichen. Typischerweise werden dann Bonddrähte und/oder Leadframes mit den Halbleiterbauelementen und Steuerpins verbunden, um Spannungs- und Steuersignale zuzuführen. Dabei ist es weiter bekannt, ein solches Leistungsmodul mit einer Vergussmasse zu überziehen, wobei die Leadframes und Steuerpins mindestens partiell nicht mit Vergussmasse bedeckt sind. Die Isolationsschicht ist ab bestimmten Leistungsklassen eine Keramik, die beispielsweise aus Siliziumnitrid oder Aluminiumnitrid besteht. Diese Leistungsmodule erzeugen eine große Verlustwärme, die abgeführt werden muss.

Dabei ist es z.B. bekannt, das Leistungsmodul mit seiner zweiten Metallisierung mit einer Metallplatte zu verbinden, die dann mit einem Kühlkörper verbunden wird.

Weiter ist es auch bekannt, das Leistungsmodul als Teil des Kühlkörpers auszubilden. Dabei wird das Leistungsmodul auf ein zweites Teil des Kühlkörpers aufgesetzt und verbunden, wobei dann das Leistungsmodul und der zweite Teil des Kühlkörpers einen umlaufend geschlossenen Kühlkörper bilden, in dem ein Kühlmedium wie z.B. Luft, Wasser, Wasser-Glykol Gemisch, Silikonöl etc. strömen kann. Dabei steht die zweite Metallisierung in direktem Kontakt mit dem Kühlmedium.

Ein solches gattungsgemäßes Leistungsmodul ist aus der WO 2020/011905 A1 bekannt. Dort wird weiter vorgeschlagen, die Oberfläche der zweiten Metallisierung derart zu strukturieren, dass es zu einer Oberflächenvergrößerung kommt.

Aus der DE 10 2015 115 132 A1 ist ein Halbleitermodul bekannt, das ein Substrat aufweist. Das Substrat ist eine Isolationsschicht mit einer ersten und zweiten Metallisierung. Auf der ersten Metallisierung ist ein Halbleiterbauelement angeordnet. Weiter ist ein Träger mit einer Stift- oder Rippenkühlstruktur vorgesehen, der mit der zweiten Metallisierung verbunden ist. Das Substrat und das Halbleiterbauelement sind vergossen, wobei elektrisch leitende Zuleitungen sich durch die Vergussmasse erstrecken.

Der Erfindung liegt das technische Problem zugrunde, ein Leistungsmodul mit Kühlkörper zu schaffen, das eine verbesserte Wärmeabfuhr aufweist. Ein weiteres technisches Problem ist die Schaffung eines hierfür geeigneten Trägers.

Die Lösung des technischen Problems ergibt sich durch ein Leistungsmodul mit Kühlkörper mit den Merkmalen des Anspruchs 1 sowie einen Träger mit den Merkmalen des Anspruchs 9. Weitere vorteilhafte Ausgestaltungen der Erfindung ergeben sich aus den Unteransprüchen.

Das Leistungsmodul mit Kühlkörper weist mindestens einen Träger auf. Der Träger weist mindestens eine Isolationsschicht auf, wobei auf der Oberseite der Isolationsschicht mindestens eine erste Metallisierung aufgebracht ist, auf der mindestens ein Halbleiterbauelement angeordnet ist. An der Unterseite des Trägers ist eine zweite Metallisierung aufgebracht. Dabei ist die zweite Metallisierung ein erstes Teil des Kühlkörpers und steht direkt mit einem Kühlmedium des Kühlkörpers in Kontakt. Dabei kann die Metallisierung ggf. auch eine Beschichtung aufweisen. Dabei weist die zweite Metallisierung eine größere Fläche auf als die Isolationsschicht. Anschaulich überragt die zweite Metallisierung die Isolationsschicht. Dabei kann die zweite Metallisierung die Isolationsschicht an allen vier Kanten überragen. Es ist aber möglich, dass die zweite Metallisierung nur an zwei Kanten die Isolationsschicht überragt und an den beiden anderen Kanten nahezu bündig abschließt. Hierdurch wird die Fläche für die Wärmeabfuhr vergrößert und somit die Wärmeabfuhr verbessert. Dabei sei klargestellt, dass die Fläche als Produkt von Länge mal Breite der Schicht als Ebene zu verstehen ist. Dabei weist die zweite Metallisierung eine entsprechende Dicke auf, damit der überstehende Teil ausreichend Stabilität aufweist. Vorzugsweise ist die zweite Metallisierung mindestens 500 µm, vorzugsweise mind. 1.000 µm dick.

In einer Ausführungsform sind an der zweiten Metallisierung Rippen oder Pin-Fins (Zylinderstifte) angeordnet, die integraler Bestandteil der zweiten Metallisierung sind. Hierdurch wird die effektive Oberfläche vergrößert und die Wärmeabfuhr verbessert.

In einer weiteren Ausführungsform sind die Rippen oder Pin-Fins mit einem Boden eines zweiten Teils des Kühlkörpers verbunden, vorzugsweise verlötet. Hierdurch wird die Wärmeabfuhr weiter verbessert, da die Wärme nicht nur an das Kühlmedium abgegeben wird, sondern auch an den zweiten Teil des Kühlkörpers, der eine gute Wärmeleitfähigkeit aufweist.

In einer alternativen Ausführungsform sind an einem Boden eines zweiten Teils des Kühlkörpers Turbulenzbleche, Pin-Fins und/oder Rippen angeordnet, die mit der zweiten Metallisierung in Kontakt stehen oder mit dieser verbunden sind. Beispielsweise wird beim Aufsetzen des Leistungsmoduls auf den zweiten Teil des Kühlkörpers die zweite Metallisierung gegen die Turbulenzbleche, Pin-Fins und/oder Rippen gedrückt, sodass diese in Kontakt stehen oder aber diese werden z.B. verklebt oder verlötet.

In einer weiteren Ausführungsform besteht die zweite Metallisierung aus Aluminium, da dieses sehr beständig gegenüber Wasser als Kühlmedium ist.

In einer weiteren Ausführungsform besteht die erste Metallisierung aus Kupfer, das eine sehr gute Wärmespreizung aufweist. Dabei sind auch Ausführungen möglich, wo auf der Oberseite zwei erste Metallisierungen aufgebracht sind, beispielsweise Aluminium und Kupfer, wobei das Aluminium auf der Isolationsschicht aufgebracht ist und auf die Aluminiumschicht eine Kupferschicht aufgebracht ist, die dann für die Kontaktierung der Halbleiterbauelemente zuständig ist.

In einer weiteren Ausführungsform besteht der zweite Teil des Kühlkörpers aus Aluminium oder aus Kupfer mit Vernickelung. Es sind aber auch Ausführungen aus Kunststoff möglich.

In einer weiteren Ausführungsform ist die zweite Metallisierung mit mehreren Isolationsschichten verbunden, auf denen jeweils eine erste Metallisierung angeordnet ist. Beispielsweise sind drei Isolationsschichten mit einer ersten Metallisierung vorgesehen, auf denen jeweils eine Halbbrücke angeordnet ist, sodass dann die drei Halbbrücken einen Wechselrichter bilden. Alle drei Isolationsschichten sind dann mit einer einzigen zweiten Metallisierung verbunden.

Der Träger für ein Leistungsmodul umfasst eine Isolationsschicht und mindestens eine erste Metallisierung, die auf die Oberseite der Isolationsschicht aufgebracht ist, wobei an der Unterseite der Isolationsschicht eine zweite Metallisierung aufgebracht ist, die eine größere Fläche als die Isolationsschicht aufweist. Vorzugsweise ist die Isolationsschicht eine Keramik. Weiter vorzugsweise ist die Metallisierung aus Kupfer und die zweite Metallisierung aus Aluminium.

Die Erfindung wird nachfolgend anhand bevorzugter Ausführungsbeispiele näher erläutert. Die Figuren zeigen:
- Fig. 1: eine schematische Seitenansicht eines Leistungsmoduls in einer ersten Ausführungsform,
- Fig. 2: eine schematische Seitenansicht eines Leistungsmoduls in einer zweiten Ausführungsform,
- Fig. 3: einen schematischen Querschnitt durch ein Leistungsmodul mit einem Kühlkörper in einer ersten Ausführungsform,
- Fig. 4: einen schematischen Querschnitt durch ein Leistungsmodul mit einem Kühlkörper in einer zweiten Ausführungsform,
- Fig. 5: einen schematischen Querschnitt durch ein Leistungsmodul mit einem Kühlkörper in einer dritten Ausführungsform,
- Fig. 6: einen schematischen Querschnitt durch ein Leistungsmodul mit einem Kühlkörper in einer vierten Ausführungsform,
- Fig. 7: eine schematische Seitenansicht auf ein Leistungsmodul (Stand der Technik),
- Fig. 8: eine schematische Seitenansicht auf ein alternatives Leistungsmodul (Stand der Technik),
- Fig. 9: einen schematischen Querschnitt durch ein Leistungsmodul mit einem Kühlkörper (Stand der Technik) und
- Fig. 10: einen schematischen Querschnitt durch ein alternatives Leistungsmodul mit einem Kühlkörper.

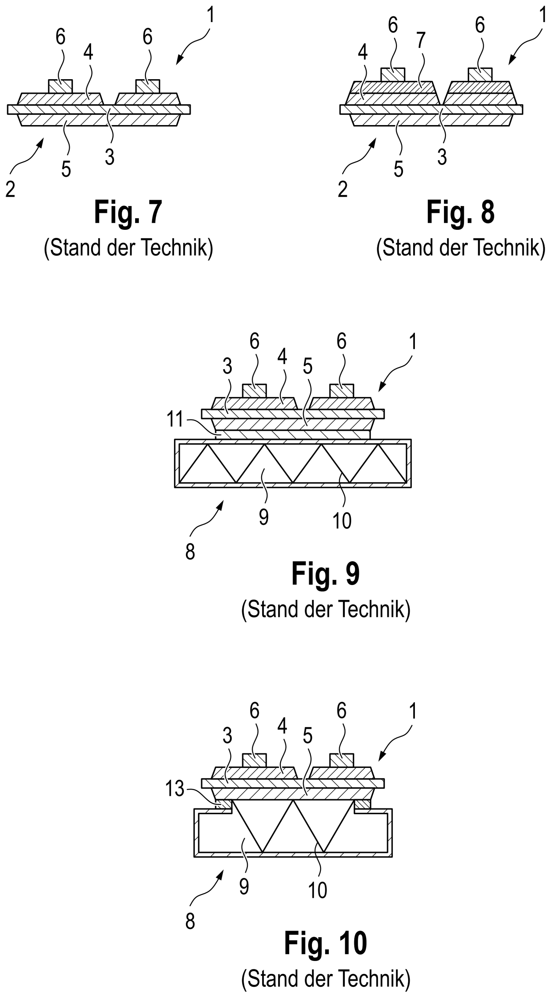

Bevor die Erfindung näher beschrieben wird, soll zunächst anhand der Figuren 7 bis 10 der Stand der Technik näher erläutert werden. In der Fig. 7 ist eine Seitenansicht eines Leistungsmoduls 1 stark vereinfacht dargestellt. Das Leistungsmodul 1 weist einen Träger 2 auf, der eine Isolationsschicht 3 aufweist, die vorzugsweise als Keramik ausgebildet ist. Auf der Oberseite der Isolationsschicht 3 ist eine erste Metallisierung 4 aufgebracht, die strukturiert ist. Weiter weist der Träger 2 an der Unterseite eine zweite Metallisierung 5 auf. Auf der ersten Metallisierung 4 sind Halbleiterbauelemente 6 wie beispielsweise MOSFETs oder IGBTs angeordnet. Dabei ist das Material der beiden Metallisierungen 4, 5 gleich und ist beispielsweise Kupfer oder Aluminium. Dabei ist flächenmäßig die erste Metallisierung 4 gleich groß wie die zweite Metallisierung (äußere Abmessungen), wobei die Isolationsschicht 3 eine größere Fläche aufweist, damit die erste Metallisierung 4 und die zweite Metallisierung 5 vollständig auf der Isolationsschicht 3 aufliegen. In der Fig. 8 ist eine alternative Ausführungsform dargestellt, bei der zwei erste Metallisierungen 4, 7 existieren. Dabei ist die erste Metallisierung 4, die auf der Isolationsschicht 3 aufliegt, aus Aluminium und die andere Metallisierung 7 aus Kupfer, wobei die zweite Metallisierung 5 ebenfalls aus Aluminium ist. Hinsichtlich der Flächen gilt das zu Fig. 7 Gesagte. In Fig. 9 und Fig. 10 sind dann zwei mögliche Ausführungsformen dargestellt, wie ein solches Leistungsmodul 1 mit einem Kühlkörper 8 verbunden werden kann. In der Fig. 9 ist der Kühlkörper 8 ein vollständig selbständiger Kühlkörper 8, in dem ein Kühlmedium 9 ist (z.B. Luft oder Wasser). In dem Kühlkörper 8 sind Turbulenzbleche 10 angeordnet. Das Leistungsmodul 1 wird dabei über eine zusätzliche Schicht 11 auf dem Kühlkörper 8 angeordnet. Beispielsweise ist die zusätzliche Schicht 11 eine Metallplatte, die mit dem Kühlkörper 8 verlötet, verschweißt oder gesintert ist. Andere Fügeverfahren sind denkbar (z.B. Verkleben). Durch die zusätzliche Schicht 11 ist die Wärmeübertragung träger. In der Fig. 10 ist dargestellt, dass das Leistungsmodul 1, insbesondere die zweite Metallisierung 5, ein erstes Teil des Kühlkörpers 8 ist, das mit einem zweiten Teil 12 zu dem kompletten Kühlkörper verbunden wird. Die Verbindung 13 kann beispielsweise eine Löt- oder Sinterverbindung sein. Hierdurch ist die zweite Metallisierung 5 im direkten Kontakt mit dem Kühlmedium 9, wobei jedoch die Kühlfläche nicht sehr groß ist.

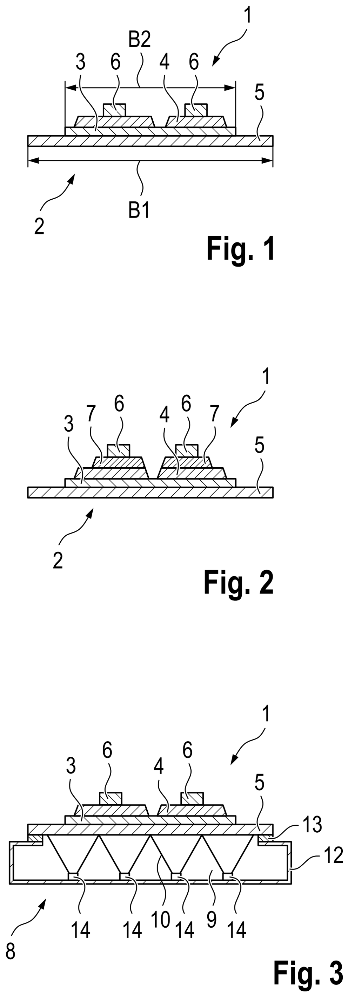

In der Fig. 1 ist ein erfindungsgemäßes Leistungsmodul 1 dargestellt. Im Unterschied zu dem Leistungsmodul 1 gemäß Fig. 7 ist die Fläche der zweiten Metallisierung 5 größer als die Fläche der Isolationsschicht 3. Wie man der Fig. 1 entnehmen kann, ist die Breite B1 der zweiten Metallisierung 5 größer als die Breite B2 der Isolationsschicht 3. Die Länge (also die Ausdehnung in Richtung senkrecht zur Papierebene) der zweiten Metallisierung 5 kann gleich der Länge der Isolationsschicht 3 sein oder aber auch größer. Dabei kann die erste Metallisierung 4 und die zweite Metallisierung 5 aus dem gleichen Material bestehen (z.B. Kupfer oder Aluminium) oder aber aus verschiedenen Metallen, wobei vorzugsweise die erste Metallisierung 4 aus Kupfer besteht und die zweite Metallisierung 5 aus Aluminium besteht. In der Fig. 2 ist ein erfindungsgemäßer Aufbau für ein Leistungsmodul 1 dargestellt, das zwei erste Metallisierungen 4, 7 aufweist (siehe auch Fig. 8).

In der Fig. 3 ist der Zusammenbau des Leistungsmoduls 1 gemäß Fig. 1 mit einem zweiten Teil 12 dargestellt, um einen Kühlkörper 8 auszubilden. Dabei ist die Kühlfläche gegenüber dem Stand der Technik gemäß Fig. 10 erheblich vergrößert, sodass entsprechend schneller mehr Wärme abgeführt werden kann. Die Turbulenzbleche 10 sind dabei entweder Bestandteil der zweiten Metallisierung 5 oder separate Bauteile und über eine Verbindung 14 mit dem Boden des zweiten Teils 12 verbunden. Bei Ausführungen, wo das Turbulenzblech 10 ein separates Bauteil ist, wird bei der Befestigung des Leistungsmoduls 1 mit dem Teil 12 die zweite Metallisierung 5 gegen die Turbulenzbleche 10 gedrückt, sodass diese verbunden sind. Hierdurch findet ein zusätzlicher Wärmetransort in den Boden des zweiten Teils 12 statt, was die Wärmeabfuhr weiter verbessert.

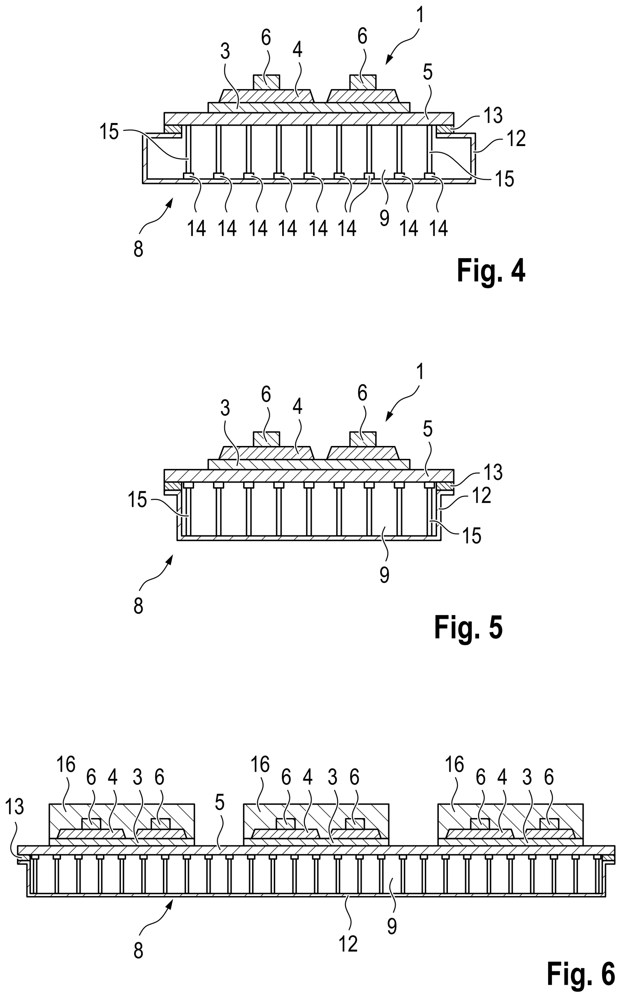

In der Fig. 4 und Fig. 5 sind alternativ Ausführungsformen des Leistungsmoduls 1 mit Kühlkörper dargestellt, wobei anstelle der Turbulenzfläche 10 Pin-Fins 15 vorgesehen sind, die in Fig. 4 integraler Bestandteil der zweiten Metallisierung 5 sind und in der Fig. 5 integraler Bestandteil des Bodens des zweiten Teils 12 des Kühlkörpers 8, wobei durch die Verbindung 14 die Anbindung von der zweiten Metallisierung 5 zum Boden hergestellt wird.

In der Fig. 6 ist eine weitere alternative Ausführungsform dargestellt. Dabei ist die zweite Metallisierung 5 mit mehreren Isolationsschichten 3 verbunden, auf denen jeweils eine erste Metallisierung 4 und Halbleiterbauelemente 6 angeordnet sind. Die Isolationsschichten 3 sind dabei räumlich getrennt und stellen Teil-Leistungsmodule mit ihren zugeordneten Halbleiterbauelementen 6 dar. Jedes Teil-Leistungsmodul kann beispielsweise eine Halbbrückenschaltung mit mehreren Leistungstransistoren sein, wobei dann die drei Teil-Leistungsmodule einen Wechselrichter bilden. Weiter ist schematisch dargestellt, dass die Teil-Leistungsmodule mit einer Vergussmasse 16 (z.B. einer Moldmasse) vergossen sind.

### Bezugszeichenliste

- 1: Leistungsmodul
- 2: Träger
- 3: Isolationsschicht
- 4: erste Metallisierung
- 5: zweite Metallisierung
- 6: Halbleiterbauelement
- 7: erste Metallisierung
- 8: Kühlkörper
- 9: Kühlmedium
- 10: Turbulenzblech
- 11: zusätzliche Schicht
- 12: zweites Teil
- 13: Verbindung
- 14: Verbindung
- 15: Pin-Fin
- 16: Vergussmasse
- B1: Breite der zweiten Metallisierung
- B2: Breite der Isolationsschicht

## Patentansprüche

1. Leistungsmodul (1) mit Kühlkörper (8), wobei das Leistungsmodul (1) mindestens einen Träger (2) aufweist, wobei der mindestens eine Träger (2) eine Isolationsschicht (3) aufweist, wobei auf der Oberseite der Isolationsschicht (3) mindestens eine erste Metallisierung (4, 7) aufgebracht ist, auf der mindestens ein Halbleiterbauelement (6) angeordnet ist, wobei an der Unterseite der Isolationsschicht (3) eine zweite Metallisierung (5) aufgebracht ist, wobei die zweite Metallisierung (5) ein erstes Teil des Kühlkörpers (8) ist und direkt mit einem Kühlmedium (9) des Kühlkörpers (8) in Kontakt steht,
**dadurch gekennzeichnet, dass**
die zweite Metallisierung (5) eine größere Fläche als die Isolationsschicht (3) aufweist.

2. Leistungsmodul nach Anspruch 1, **dadurch gekennzeichnet, dass** an der zweiten Metallisierung (5) Rippen oder Pin-Fins (15) angeordnet sind.

3. Leistungsmodul nach Anspruch 2, **dadurch gekennzeichnet, dass** die Rippen oder Pin-Fins (15) mit einem Boden eines zweiten Teils (12) des Kühlkörpers (8) verbunden sind.

4. Leistungsmodul nach Anspruch 1, **dadurch gekennzeichnet, dass** an einem Boden eines zweiten Teils (12) des Kühlkörpers (8) Turbulenzbleche (10), Pin-Fins (15) und/oder Rippen angeordnet sind, die mit der zweiten Metallisierung (5) in Kontakt stehen oder mit dieser verbunden sind.

5. Leistungsmodul nach einem der vorangegangenen Ansprüche, **dadurch gekennzeichnet, dass** die zweite Metallisierung (5) aus Aluminium besteht.

6. Leistungsmodul nach einem der vorangegangenen Ansprüche, **dadurch gekennzeichnet, dass** die erste Metallisierung (4) aus Kupfer besteht.

7. Leistungsmodul nach einem der vorangegangenen Ansprüche, **dadurch gekennzeichnet, dass** der zweite Teil (12) des Kühlkörpers (8) aus Aluminium oder aus Kupfer mit Vernickelung besteht.

8. Leistungsmodul nach einem der vorangegangenen Ansprüche, **dadurch gekennzeichnet, dass** die zweite Metallisierung (5) mit mehreren Isolationsschichten (3) verbunden ist, auf denen jeweils eine erste Metallisierung (4) angeordnet ist.

9. Träger (2) für ein Leistungsmodul (1), umfassend eine Isolationsschicht (3) und eine auf der Oberseite der Isolationsschicht (3) aufgebrachte mindestens eine erste Metallisierung (4) , wobei an der Unterseite der Isolationsschicht (3) eine zweite Metallisierung (5) aufgebracht ist,
**dadurch gekennzeichnet, dass**
die zweite Metallisierung (5) eine größere Fläche als die Isolationsschicht (3) aufweist.

10. Träger nach Anspruch 9, **dadurch gekennzeichnet, dass** die erste Metallisierung (4) aus Kupfer und die zweite Metallisierung (5) aus Aluminium besteht.
